# EUROPEAN PATENT SPECIFICATION

(11) **EP 0 216 839 B1**
(45) Date of publication and mention of the grant of the patent: **01.06.1994**
(21) Application number: 86901923.2
(22) Date of filing: 06.03.1986
(51) Int. Cl.: H04J 3/04, H04J 14/00

(54) **OPTICAL SIGNAL PROCESSING**
OPTISCHE SIGNALVERARBEITUNG
TRAITEMENT DE SIGNAUX OPTIQUES

(30) Priority: 07.03.1985 GB 8505940; 18.04.1985 GB 8509983; 18.04.1985 GB 8509984
(43) Date of publication of application: 08.04.1987
(73) Proprietor: BRITISH TELECOMMUNICATIONS public limited company, London EC1A 7AJ (GB)
(72) Inventor: SMITH, David, Robert Oakburn, Harriers Walk, Suffolk IP13 OHA (GB); HOOPER, Raymond, Charles 3 Netherwood Court, Suffolk IP5 7TT (GB)
(74) Representative: Roberts, Simon Christopher
(86) International application number: PCT/GB86/00127
(87) International publication number: WO 86/05342

(56) References cited:
- WO-A-85/04064
- US-A-35 210 68
- US-A-45 077 76
- Journal of Lightwave Technology, vol. LT-3, no. 1, Febr. 1985, New York, (US), H. Haga: "An integrated 1X4 high-speed optical switch and its applications to a time demultiplexer", pages 116-120

## Description

The use of optical signals to transmit information is becoming much more common and these optical signals are capable of carrying in multiplexed form information from a plurality of sources. This use of optical signals opens up possibilities for sending information at GBit/second rates but this leads to a problem in that current electronic logic is not yet available to separate an incoming optical signal at these bit rates into its component channels.

US 3,521,068 discloses a multiplex communication system in which N trains of short equally spaced pulses are produced. In the path of each of the N trains is a modulator, a mirror and a beamsplitter, each modulator being controlled by an independant data channel. The optical paths transversed by the N trains, before they are all recombined in a single train, are each of a different and characteristic length. Thus, when combined, the N single trains of short pulses are non-overlapping in space. The optical demultiplexing scheme disclosed is as recited in the preamble of claim 1 in that it comprises means for passing the single train through a beam spreader and aperture plate to produce N single trains of pulses each carrying the indentical information as the single train. The system of US 3,521,068 completes the demultiplexing of the N original trains as follows. Each of the N single trains is combined with optical clock pulses such that the optical clock pulses on each of the N single trains is coincident with, and polarized orthogonally to, the pulses corresponding to one of the N original trains.

There are provided detectors capable of detecting only the coincidence of a pulse in the transmitted train and a corresponding clock pulse, a detector being associated with each of the N single trains. In this manner each detector will detect only the pulses corresponding to one of the original trains.

EP-A-0172887 Priority date 5th March 1984; published on 12th September 1985 after the priority date of the present application) describes an optical demultiplexer in which delays are inserted into parallel versions of the incoming multiplexed signal which are fed to respective gates while a clock signal is extracted from the incoming signal and used to control the gates so that the incoming signal is demultiplexed. A problem with this arrangement is that there is no indication of how the demultiplexed channel can be identified.

JP-A-59/198033 describes an optical demultiplexer in which the incoming signal is split into a number of portions. In one example, each portion is fed to a respective sampling device which is clocked by an appropriately delayed clock signal while in the other example the portions of the clock signals themselves are delayed and then fed to a common sampling device. In both cases, the sampling device(s) output the demultiplexed signals. JP-A-52/107704 describes an optical demultiplexer in which an incoming optical signal is split into portions and fed to respective sampling devices via respective lines which impart suitable delays so that a common clock signal can be applied to the sampling devices to demultiplex the incoming signal. In both these cases, no attempt is made to explain how the signals can be identified, each system relying on accurate synchronisation.

According to the present invention an optical demultiplexer for demultiplexing an n-channel, time division multiplexed, optical input signal into n subsidiary optical signals, one corresponding to each of the n-channels includes: a regenerator including a clock signal generator for generating a clock signal with a frequency related to the bit rate of the optical input signal; an optical splitter for forming n portions of the optical signal; a number of optical sampling devices; the optical splitter being optically coupled with the optical sampling devices for feeding one of the portions of the optical signal in parallel to each of sampling devices; and a control means responsive to the clock signal for regularly actuating each of the sampling devices so that each passes a sample of the optical input signal which constitutes a respective one of the subsidiary optical channels corresponding to a respective one of the n channels, and is characterized in that the regenerator generates from the time division multiplexed input signal, a channel identifier which identifies the n channels; and in that the demultiplexer further includes a marker detect and matrix switch circuit which receives the subsidiary optical channels and is responsive to the channel identifier to identify the subsidiary optical channels.

Preferably, the optical sampling means are actuated simultaneously and there are included delay means positioned between the optical splitter and the n optical sampling devices to impart different delays to these n portions of the signal, the delays being chosen so that the portion of the optical signal passed through each sampling device corresponds to a respective channel.

Preferably the delay means are arranged to enable all channels to be sampled simultaneously.

The system may further comprise n conversion means for converting the subsidiary optical signals into corresponding electrical signals. The conversion means may comprise conventional regenerators.

Where conversion means are provided, the n optical sampling devices will be optically coupled with respective ones of the conversion means.

The optical sampling devices may conveniently comprise optical signal modulators such as electro-optic modulators.

The delay means preferably comprises optical delay means. For example, the delay means may be positioned between the optical splitter and the n optical sampling devices to impart different delays to those portions of the optical input signal fed to at least n-1 of the optical sampling devices so that the optical sampling devices can be sampled simultaneously by the control means the delays being chosen such that the portion of each signal which is passed through the sampling devices corresponds to a respective channel. The delay means may for example be provided by different lengths of optical waveguide (such as optical fibre) between the optical splitter and the sampling devices.

In an alternative arrangement, the delay means is non-optical and may be arranged to cause the control means to actuate the sampling devices in succession whereby the optical signals fed to the optical sampling devices are successively sampled.

The delays imparted by the delay means will typically be integral multiples (not necessarily equally spaced) of a time T, where the bit rate of the multiplexed input signal 1/T bit/second.

Preferably, where conversion means is provided the clock signal generator feeds the clock signal to a divide-by-n circuit having an output connected with the conversion means.

Preferably, the clock signal generator is responsive to the optical input signal to determine the bit rate of the optical input signal and to generate a corresponding clock signal.

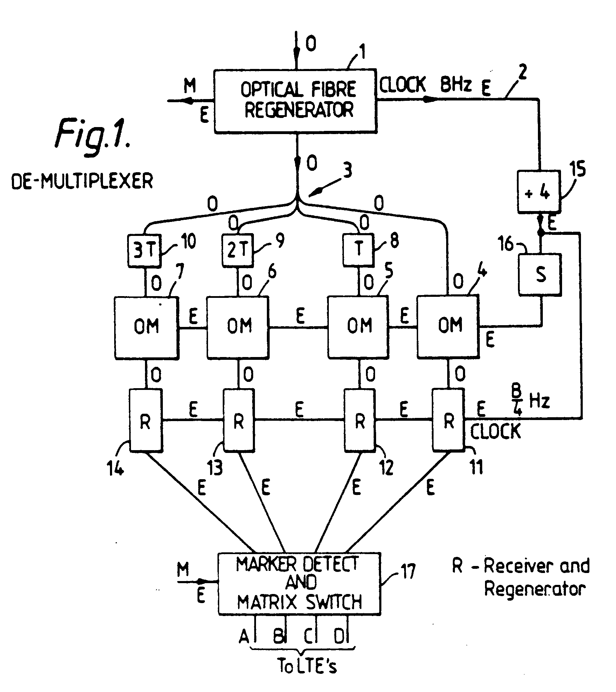

An example of an optical signal processing system according to the invention will now be described with reference to the accompanying drawings, in which:-
Figure 1 is a schematic block diagram.

The system shown in Figure 1 comprises an optical fibre regenerator 1 to which an incoming optical signal is fed. In this example, it will be assumed that the optical input signal carries four channels at a bit rate of B bits/second. The optical fibre regenerator 1 monitors the incoming signal and generates an electrical clock signal with frequency BHz on a line 2. The regenerator 1 also extracts a marker which will be described below.

The incoming optical signal is then passed via optical fibre to a four way optical splitter 3 which feeds the optical signal in parallel to four electro-optic modulators 4-7. Conveniently, the optical signals are guided along optical fibres such as monomode optical fibres. The modulators could be fabricated on a single substrate of appropriate electro-optical material such as lithium niobate, GaInAsP and the like.

Delay units 8-10 are positioned between the optical splitter 3 and the modulators 5-7 respectively. The delay units 8-10 impart delays of T, 2T, and 3T on the optical signals passing through them so that at any instant different portions of the optical input signal are applied to the modulators 4-7. The delays imparted by the delay units 8-10 are chosen so that the portion of the optical input signal at each modulator 4-7 at any instant corresponds to the same portion of successive ones of the four input channels. In this example, the input channels are equally spaced in the original multiplexed signal so that $\text{T = 1/B}$ seconds.

Conveniently the delay units 8 to 10 are constituted by different lengths of optical fibre.

The modulators 4-7 act as optical switches to connect periodically the incoming optical signals with respective regenerators 11-14. Clearly, if the modulators 4-7 are switched to connect the incoming signals with the regenerators 11-14 at a rate of B/4 bit/second then successive bits of the same channel will be applied to respective ones of the regenerators 11-14.

To achieve the correct sampling, the clock signal from the optical fibre regenerator 1 is fed along the line 2 to a + 4 circuit 15 which generates a subsidiary clock signal having a frequency of B/4 Hz. This subsidiary clock signal is fed to a sampling circuit 16 which regenerates the clock signal at B/4Hz but with a pulse width of 1/B the pulse width of the original clock signal. This is applied simultaneously to the modulators 4-7 which pass samples of the incoming optical signals to the regenerators 11-14. The B/4 Hz subsidiary clock signal is applied simultaneously to the regenerators 11-14 which thus convert every fourth incoming sampled optical signal to its electrical equivalent.

The electrical signals are then fed to a marker detect and matrix switch circuit 17.

The original optical input signal carries additionally a marker or identification signal which typically could be a low level (few %), low frequency (kHz) modulation of a signal amplitude to identify one of the channels. This marker is extracted by the optical fibre regenerator 1 in a conventional manner and fed in electrical form to the marker detect and matrix switch circuit 17. The circuit 17 determines from the marker the identification of each of the four incoming channels. The circuit 17 then connects each of the incoming channels with a respective one of four line terminal equipment units (not shown).

The original multiplexed signal may be generated in any conventional manner or by systems similar to those described in our copending patent application of even date entitled "Line Transmission Systems".

With these demultiplexing systems, multiplexed optical signals at very high bit rates for example up to 17 or 18 G bits/second can be demultiplexed.

## Claims

1. An optical demultiplexer for demultiplexing an n-channel, time division multiplexed, optical input signal into n subsidiary optical signals, one corresponding to each of the n-channels including: a regenerator (1) including a clock signal generator for generating a clock signal with a frequency related to the bit rate of the optical input signal; an optical splitter (3) for forming n portions of the optical signal; a number of optical sampling devices (4,5,6,7); the optical splitter (3) being optically coupled with the optical sampling devices (4,5,6,7,) for feeding one of the portions of the optical signal in parallel to each of sampling devices (4,5,6,7); and a control means (15) responsive to the clock signal for regularly actuating each of the sampling devices (4,5,6,7) so that each passes a sample of the optical input signal which constitutes a respective one of the subsidiary optical channels corresponding to a respective one of the n channels, characterized in that the regenerator (1) generates from the time division multiplexed input signal, a channel identifier which identifies the n channels; and in that the demultiplexer further includes a marker detect and matrix switch circuit (17) which receives the subsidiary optical channels and is responsive to the channel identifier to identify the subsidiary optical channels.

2. An optical demultiplexer as claimed in claim 1 in which the optical sampling means (4,5,6,7) are actuated simultaneously and there are included delay means (8,9,10) positioned between the optical splitter (3) and the n optical sampling devices (4,5,6,7) to impart different delays to these n portions of the signal, the delays being chosen so that the portion of the optical signal passed through each sampling device (4,5,6,7) corresponds to a respective channel.

3. An optical demultiplexer as claimed in claim 2 in which the optical splitter (3) is optically coupled to the optical sampling devices (4,5,6,7) by optical waveguides of different lengths.

4. An optical demultiplexer as claimed in claim 3 in which the optical waveguides are optical fibres.

5. An optical demultiplexer as claimed in claim 1 in which the optical splitter (3) and the n optical sampling devices (4,5,6,7) are optically coupled so that the same channel arrives simultaneously at each optical sampling device (4,5,6,7), and the control means (15) is arranged to actuate each optical sampling device (4,5,6,7) to sample a respective one of the channels.

6. An optical demultiplexer according to any one of claims 1, 2, 3, 4 or 5 wherein the optical sampling devices (4,5,6,7) comprise optical signal modulators.

7. An optical demultiplexer according to any one of claims 1 to 6 further comprising n conversion means (R) for converting the subsidiary optical signals into corresponding electrical signals, wherein the n conversion means (R) are optically coupled to receive the subsidiary optical signals from respective one of the optical sampling devices (4,5,6,7).

8. An optical demultiplexer according to claim 7, wherein the clock signal generator feeds the clock signal to a divide-by-n circuit (15) having an output connected with the conversion means (R).

9. An optical demultiplexer according to any of the preceding claims, wherein the regenerator (1) extracts an identification signal in the form of a low frequency modulation or the time division multiplexed, optical input signal.

## Patentansprüche

1. Optischer Demultiplexer zum Demultiplexieren eines optischen, zeitmultiplexierten n-Kanal-Eingangssignals in n optische Tochtersignale, von denen jeweils eines jedem der n-Kanäle entspricht, wobei der Demultiplexer aufweist: einen Regenerator (1) mit einem Taktsignalgenerator zur Erzeugung eines Taktsignals mit einer auf die Bitrate des optischen Eingangssignals bezogenen Frequenz, einen optischen Teiler (3) zur Bildung von n Abschnitten des optischen Signals; eine Anzahl optischer Abtasteinrichtungen (4, 5, 6, 7); wobei der optische Teiler (3) optisch mit den optischen Abtasteinrichtungen (4, 5, 6, 7) gekoppelt ist, um einen der Abschnitte des optischen Signals parallel an jede der Abtasteinrichtungen (4, 5, 6, 7) zu liefern; und eine Steuereinrichtung (15), die auf das Taktsignal anspricht, um jede der Abtasteinrichtungen (4, 5, 6, 7) regelmäßig auszulösen, so daß jede Einrichtung eine Abtastprobe des optischen Eingangssignals übermittelt, das einen jeweiligen einzelnen Kanal der optischen Tochterkanäle bildet, der einem jeweiligen einzelnen Kanal der n Kanäle entspricht,
**dadurch gekennzeichnet,**
daß der Regenerator (1) aus dem zeitmultiplexierten Eingangssignal einen Kanalbezeichner erzeugt, der die n Kanäle identifiziert; und daß der Demultiplexer weiter eine Markenerkennungs- und Matrixkoppelschaltung (17) umfaßt, die die optischen Tochterkanäle empfängt und auf den Kanalbezeichner anspricht, um die optischen Tochterkanäle zu identifizieren.

2. Optischer Demultiplexer nach Anspruch 1, bei dem die optischen Abtasteinrichtungen (4, 5, 6, 7) gleichzeitig ausgelöst werden, und daß Verzögerungseinrichtungen (8, 9, 10) einbezogen sind, die zwischen dem optischen Teiler (3) und den n optischen Abtasteinrichtungen (4, 5, 6, 7) angeordnet sind, um den n Abschnitten des Signals unterschiedliche Verzögerungen zu erteilen, wobei die Verzögerungen so gewählt sind, daß der durch jede Verzögerungseinrichtung (4, 5, 6, 7) hindurch übermittelte Abschnitt des optischen Signals einem jeweiligen Kanal entspricht.

3. Optischer Demultiplexer nach Anspruch 2, bei dem der optische Teiler (3) durch Lichtwellenleiter unterschiedlicher Länge optisch an die optischen Abtasteinrichtungen (4, 5, 6, 7) angekoppelt ist.

4. Optischer Demultiplexer nach Anspruch 3, bei dem die Lichtwellenleiter Lichtleitfasern sind.

5. Optischer Demultiplexer nach Anspruch 1, bei dem der optische Teiler (3) und die n optischen Abtasteinrichtungen (4, 5, 6, 7) optisch so gekoppelt sind, daß derselbe Kanal gleichzeitig an jeder optischen Abtasteinrichtung (4, 5, 6, 7) ankommt, und daß die Steuereinrichtung (15) so ausgelegt ist, daß sie jede optische Abtasteinrichtung (4, 5, 6, 7) auslöst, um einen jeweiligen einzelnen der Kanäle abzutasten.

6. Optischer Demultiplexer nach einem beliebigen Anspruch 1, 2, 3, 4 oder 5, bei dem die optischen Abtasteinrichtungen (4, 5, 6, 7) optische Signalmodulatoren umfassen.

7. Optischer Demultiplexer nach einem beliebigen Anspruch 1 bis 6, der weiter n Umwandlungseinrichtungen (R) zum Umwandeln der optischen Tochtersignale in entsprechende elektrische Signale aufweist, wobei die n Umwandlungseinrichtungen (R) optisch zum Empfangen der optischen Tochtersignale von einer jeweiligen der optischen Abtasteinrichtungen (4, 5, 6, 7) gekoppelt sind.

8. Optischer Demultiplexer nach Anspruch 7, bei dem der Taktsignalgenerator das Taktsignal an eine 1/n-Teilerschaltung (15) liefert, die einen mit der Umwandlungseinrichtung (R) verbundenen Ausgang besitzt.

9. Optischer Demultiplexer nach einem beliebigen vorhergehenden Anspruch, bei dem der Regenerator (1) ein Identifizierungssignal in Form einer Niederfrequenzmodulation des zeitmultiplexierten optischen Eingangssignals entnimmt.

## Revendications

1. Démultiplexeur optique pour le démultiplexage d'un signal optique d'entrée multiplexé dans le temps, à n canaux, en n signaux optiques subsidiaires correspondant chacun à un des n canaux, comprenant : un régénérateur (1) pourvu d'un générateur de signal d'horloge pour générer un signal d'horloge d'une fréquence liée au débit binaire du signal optique d'entrée ; un séparateur optique (3) pour former n tronçons du signal optique ; plusieurs échantillonneurs optiques (4, 5, 6, 7) ; le séparateur optique (3) étant couplé optiquement aux échantillonneurs optiques (4, 5, 6, 7) pour envoyer chaque tronçon du signal optique en parallèle à chaque échantillonneur (4, 5, 6, 7) ; et un contrôleur (15) conditionné par le signal d'horloge pour activer régulièrement chacun des échantillonneurs (4, 5, 6, 7) afin que chacun transmette un échantillon du signal optique d'entrée qui constitue un canal optique subsidiaire respectif correspondant à un des n canaux, **caractérisé** en ce que le régénérateur (1) génère, à partir du signal d'entrée multiplexé dans le temps, un identificateur de canal qui identifie les n canaux ; et en ce que le démultiplexeur comprend de plus un circuit de détection de marque et de commutation de matrice (17), qui reçoit les canaux optiques subsidiaires et est conditionné par l'identificateur de canal pour identifier les canaux optiques subsidiaires.

2. Démultiplexeur optique selon la revendication 1, dans lequel les échantillonneurs optiques (4, 5, 6, 7) sont activés simultanément, et comprenant des temporisateurs (8, 9, 10) placés entre le séparateur optique (3) et les n échantillonneurs (4, 5, 6, 7) pour appliquer une temporisation différente à ces n tronçons de signal, les temporisations étant choisies de façon à ce que le tronçon de signal optique acheminé vers chaque échantillonneur (4, 5, 6, 7) corresponde à un canal respectif.

3. Démultiplexeur optique selon la revendication 2, dans lequel le séparateur optique (3) est couplé optiquement aux échantillonneurs optiques (4, 5, 6, 7) par des guides d'ondes de longueurs différentes.

4. Démultiplexeur optique selon la revendication 3, dans lequel les guides d'ondes optiques sont des fibres optiques.

5. Démultiplexeur optique selon la revendication 1, dans lequel le séparateur optique (3) et les n échantillonneurs optiques (4, 5, 6, 7) sont couplés optiquement de façon à ce que le même canal arrive simultanément à chaque échantillonneur optique (4, 5, 6, 7), et le contrôleur (15) est conçu pour activer chaque échantillonneur optique (4, 5, 6, 7) de façon qu'il échantillonne un canal respectif.

6. Démultiplexeur optique selon l'une quelconque des revendications 1, 2, 3, 4 ou 5, dans lequel les échantillonneurs optiques (4, 5, 6, 7) comprennent des modulateurs de signal optique.

7. Démultiplexeur optique selon l'une quelconque des revendications 1 à 6 comprenant de plus n convertisseurs (R) pour convertir les signaux optiques subsidiaires en signaux électriques correspondants, dans lequel les n convertisseurs (R) sont couplés optiquement pour recevoir les signaux optiques subsidiaires de chacun des échantillonneurs (4, 5, 6, 7).

8. Démultiplexeur optique selon la revendication 7, dans lequel le générateur de signal d'horloge envoie le signal d'horloge à un circuit de division par n (15) possédant une sortie connectée aux convertisseurs (R).

9. Démultiplexeur optique selon l'une quelconque des revendications précédentes, dans lequel le régénérateur (1) extrait un signal d'identification sous la forme d'une modulation à basse fréquence du signal optique d'entrée multiplexé dans le temps.
